Europäisches Patentamt

European Patent Office

Office européen des brevets

(19)

(11) Publication number: **0 024 853**
B1

(12) **EUROPEAN PATENT SPECIFICATION**

(45) Date of publication of patent specification: **08.08.84**

(51) Int. Cl.³: **G 11 C 8/00, G 11 C 11/40**

(21) Application number: **80302789.5**

(22) Date of filing: **13.08.80**

(54) Semiconductor memory circuit including a hold current controlling circuit.

(30) Priority: **22.08.79 JP 106901/79**

(43) Date of publication of application:
**11.03.81 Bulletin 81/10**

(45) Publication of the grant of the patent:
**08.08.84 Bulletin 84/32**

(84) Designated Contracting States:
**DE FR GB NL**

(56) References cited:
**DE - A - 2 658 523**
**FR - A - 2 159 534**
**US - A - 3 736 574**
**US - A - 4 156 941**
**US - A - 4 164 791**
**US - A - 4 168 490**
**US - A - 4 168 539**

**IEEE INTERNATIONAL SOLID STATE CIRCUITS
CONFERENCE, 15 february 1979 New York US
INADACHI et al.: "A 6ns 4Kb Bipolar RAM using
switched load resistor memory cell", pages 108-
109**
**IEEE INTERNATIONAL SOLID STATE CIRCUITS
CONFERENCE, 16 february 1977, New York US
MUKAI et al.: "Ultra high speed 1K-bit RAM with
7.5ns access time", pages 78-79**

(73) Proprietor: **FUJITSU LIMITED**
**1015, Kamikodanaka Nakahara-ku
Kawasaki-shi Kanagawa 211 (JP)**

(72) Inventor: **Isogai, Hideaki**
**4-11-13 Minamisawa Higashikurume-shi
Tokyo 180-03 (JP)**

(74) Representative: **Rackham, Stephen Neil et al,
GILL JENNINGS & EVERY 53-64 Chancery Lane
London WC2A 1HN (GB)**

(56) References cited:
**IEEE JOURNAL OF SOLID STATE CIRCUITS, vol.
SC12, no. 5, october 1977 New York US
HERNDON et al.: "A static 4096-bit bipolar
random access memory", pages 524-527**
**SIEMENS FORSCHUNGS- &
ENTWICKLUNGSBERICHT, vol. 6, no. 2, 1977
München, DE ERNST et al.: "A fast bipolar 1024-
bit RAM for high-performance memory system",
pages 86-91**
**IEEE JOURNAL OF SOLID STATE CIRCUITS, vol.
SC13, No. 5, october 1978 New York US HOTTA
et al.: "A high-speed low-power 4096x1 bit
bipolar RAM" pages 651-656**

Courier Press, Leamington Spa, England.

## Description

The present invention relates to a semiconductor memory circuit and, more particularly, to a hold-current controlling circuit forming part of it.

Generally, a semiconductor memory circuit mainly comprises a large number of memory cells. The memory cells are arranged at crossing points of word lines and bit lines. A desired memory cell is selected by operating both a word decoder connected to the ends of the word lines and a bit decoder, connected to the ends of the bit lines. Data to be read is produced from the other end of a corresponding bit line to which the selected memory cell is connected, after, of course, data has been written into the memory cells.

Each memory cell is normally connected not only to a word line but also to a hold line through which a hold current flows. The hold current sustains the data which is stored in the memory cells. The hold current is absorbed by a hold-current source. It should be noted that the hold-current source absorbs a discharge current, too. The discharge current is created by electric charges held by the parasitic capacitance of the memory cells and also by stray capacitance distributed along the word lines. The greater the discharge current that can be absorbed by the hold-current source, the higher the accessing speed of the memory. Accordingly, in order to absorb the discharge current very quickly, a hold-current controlling circuit has been proposed. The hold-current controlling circuit co-operates with the hold-current source and absorbs not only the hold current but also the above mentioned discharge current created by the electric charge held by the capacitance of the circuit.

Many types of hold-current controlling circuits have been proposed and put into practical use. However, all of these prior hold-current circuits have the same disadvantage that, although each of these hold-current controlling circuits is effective for achieving a high speed accessing operation with respect to a word line which changes from a selection status to a non-selection status, the hold-current controlling circuits are not effective for achieving high speed accessing operation with respect to a word line which changes from non-selection status to a selection status. The term selection status means a condition in which a word line is being selected by a word decoder, while the term non-selection status means a condition in which a word line is not being selected by the word decoder.

One prior memory circuit is shown in US—A—4 156 941 and comprises memory cells, word lines, hold lines and bit lines connected to the memory cells, first constant-current sources connected to the hold lines, and, a hold-current controlling circuit co-operating with the first constant-current source, the hold-current controlling circuit comprising identical controlling circuit elements connected to each of the hold lines, and a second constant-current source commonly connected to the controlling circuit elements, each of the controlling circuit elements including means for absorbing electric charges from its associated hold line, when a corresponding word line changes from a selection status to a non-selection status, until the voltage level of the hold line reaches a full low level and means for blocking a flow of electric charge from its associated hold line to the second constant current source for a predetermined time interval after the corresponding word line changes from the non-selection status to the selection status when data switching from one of the memory cells to another memory cell occurs. The controlling circuit elements improve the speed of the circuit when changing from a non-selected state to a selected state of the word line but are complicated in construction and require connections to the word lines.

According to this invention, in such a memory circuit the controlling circuit elements are formed by a transistor, a diode, and a resistor and a capacitor connected in parallel the base of the transistor being connected to one end of the parallel circuit, a first output terminal of the transistor being connected to its associated hold line and a second output terminal of the transistor being connected to the second constant-current source, the diode being connected between the first output terminal and the base of the transistor, and the other end of the parallel circuit being connected to a reference voltage, the reference voltage having a value such that the diode is forward biased when its associated hold line has a full low level and is reverse biased when the associated hold line has a full high level corresponding to a selection status.

A particular example of a memory circuit in accordance with this invention will now be described and contrasted with the prior art with reference to the accompanying drawings; in which:—

Figure 1 is a block diagram of a conventional semiconductor memory circuit;

Figure 2A is a circuit diagram of a part of a semiconductor memory device including a first type of prior art hold-current controlling circuit;

Figure 2B is a circuit diagram of a part of a semiconductor memory circuit including a second type of prior art hold-current controlling circuit;

Figure 2C is a circuit diagram of a part of a semiconductor memory circuit including a hold-current controlling circuit in accordance with the present invention (the diodes referred to in claim 1 not being shown since they are incorporated into Schottky transistors $ST_{11}$—$ST_{n1}$);

Figure 3A is a graph which illustrates the operation of the circuit illustrated in Figure 2A;

Figure 3B is a graph which illustrates the operation of the circuit illustrated in Figure 2B;

Figure 3C is a graph which illustrates the operation of a circuit shown in Figure 2C; and,

Figures 4A, 4B and 4C are circuit diagrams illustrating the step-by-step operation of the hold-current controlling circuit illustrated in Figure 2C.

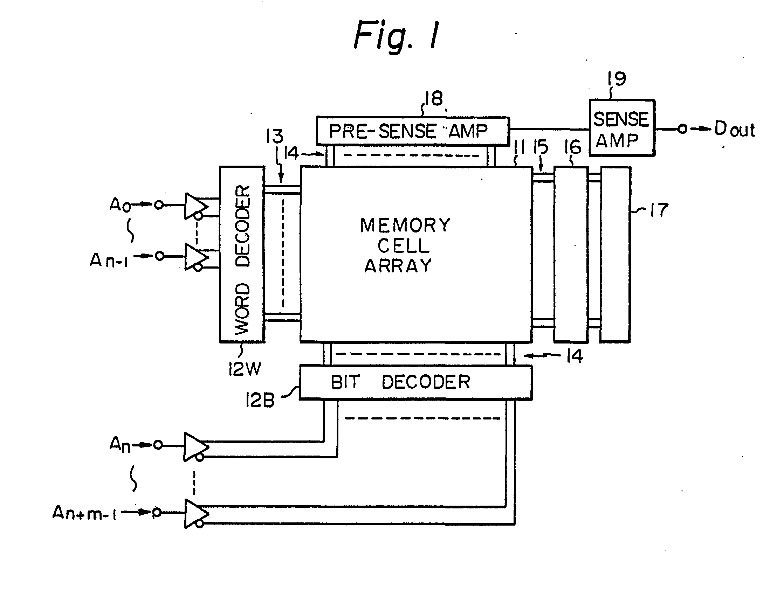

In Figure 1, which schematically illustrates an arrangement of a conventional semiconductor memory circuit, reference numeral 11 represents a memory cell array, comprised of, for example $2^n \times 2^m$ memory cells. One desired memory cell from among said plurality of memory cells is accessed by a word decoder 12W and a bit decoder 12B, in accordance with address data ($A_0$ through $A_{n-1}$) and address data ($A_n$ through $A_{n+m1}$), respectively. Word lines 13 extend in one direction from the word decoder 12W into the array 11 and bit lines 14 extend from the bit decoder 12B into the array 11. A data Dout to be read is produced from a sense amplifier 19 via the corresponding one of the bit lines and a pre-sense amplifier 18.

The memory cell array 11 is connected to a hold-current source 16 via hold lines 15. A hold current flows through the hold lines 15 and is absorbed into the source 16. The source 16 is also useful for absorbing a discharge current created by electric charges held at the parasitic capacitors of the memory cells and the stray capacitor distributed along the word line. In such a case, the discharge current must be absorbed very quickly so as to achieve a high speed accessing operation of the memory cells. In order to achieve this high speed accessing operation, a hold-current controlling circuit 17 is employed in the semiconductor memory circuit. It should be understood the invention of the present application is primarily directed to the hold-current controlling circuit 17.

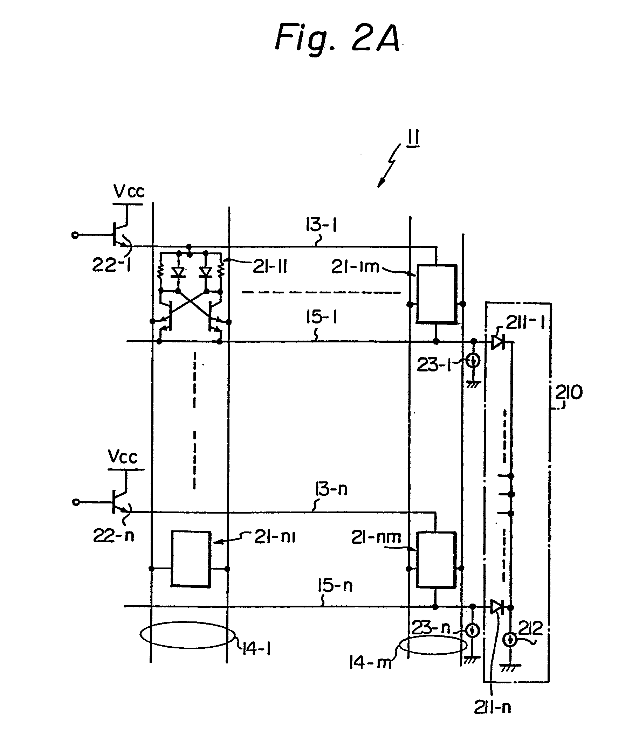

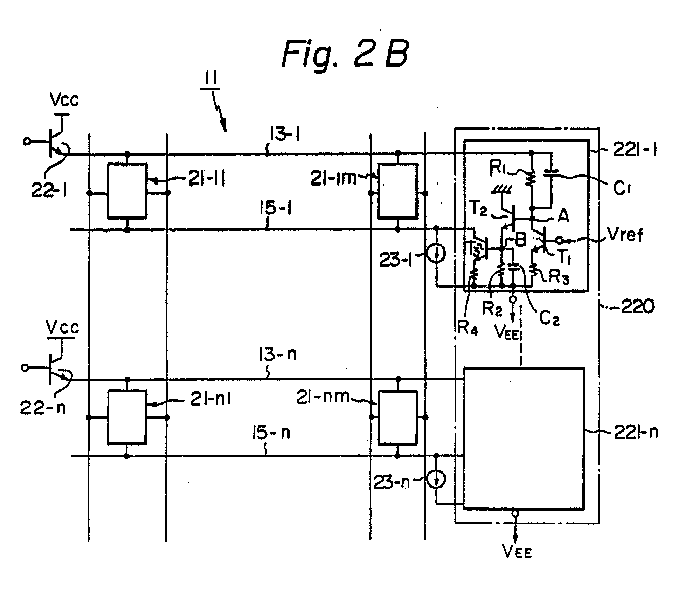

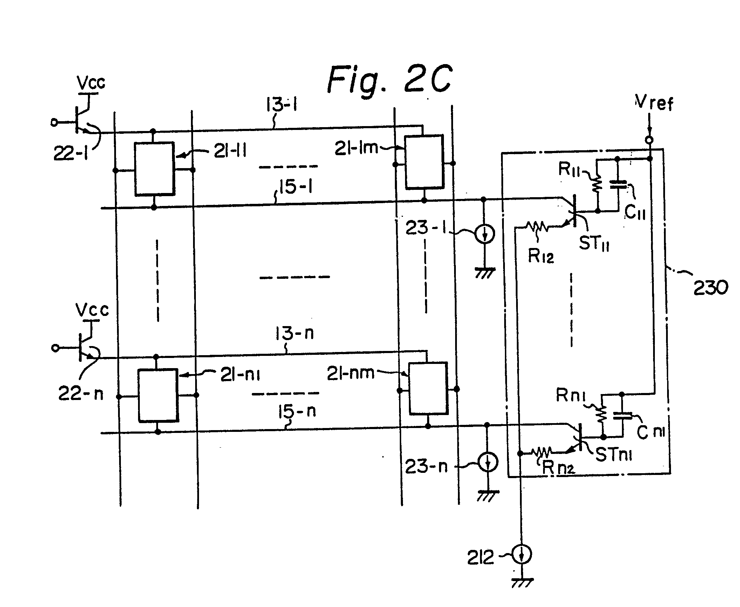

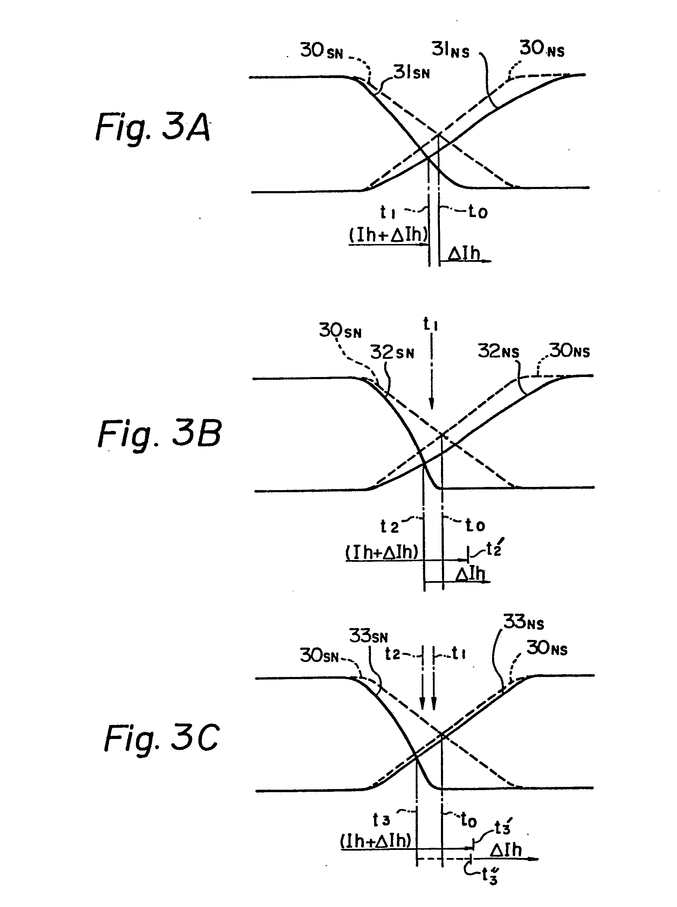

Two prior hold-current controlling circuits are shown in Figures 2A and 2B. Further, a hold-current controlling circuit according to the present invention is depicted in Figure 2C. Figures 3A, 3B and 3C are timing graphs which illustrate the operations of circuits shown in Figures 2A, 2B and 2C, respectively. In Figure 2A, the memory cell array 11 is comprised of a large plurality of memory cells, however in Figure 2A, only four memory cells 21-11, 21-1m, 21-n1 and 21-nm are illustrated. Since all of the memory cells have identical circuit arrangements only the memory cell 21-11 is illustrated in detail. As can be understood from the illustration of memory cell 21-11, each of the memory cells is basically comprised of a flip-flop including a pair of multi-emitter transistors. One of the emitters of each transistor is connected to a pair of bit lines 14-1. The other emitter of each transistor is connected to a hold line 15-1. The flip-flop of a memory cell is thereby connected between respective word lines and hold lines. In the example of Figure 2, the memory cells 21-11, 21-1m, 21-n1, and 21-nm are connected between a word line 13-1 and the hold line 15-1. The word line 13-1 is connected to a word-driver transistor 22-1. The remaining word lines are also connected to respective word-driver transistors. These word-driver transistors 22-1 through 22-n are contained in the word decoder 12W (see Figure 1). On the other hand, hold lines 15-1 through 15-n are connected to the hold-current source 16 (see Figure 1) comprised of constant-current sources 23-1 through 23-n, connected to the hold lines 15-1 through 15-n, respectively. Each of the sources 23-1 through 23-n absorbs a constant current of Ih. The constant-current sources (23-1 through 23-n) cooperate with a hold-current controlling circuit 210. The circuit 210 has diodes 211-1 through 211-n. Each of the diodes 211-1 through 211-n is connected at its anode to a hold line 15-1 through 15-n, respectively, and, at its cathode, commonly to a constant-current source 212 which absorbs a constant current of $\Delta$Ih.

If, for example, the memory cell 21-11 is accessed by an address data of the word decoder 12W (Figure 1) and the bit decoder 12B (Figure 1), first the word line 13-1 is driven by the word-driver transistors 22-1. Therefore, the word line 13-1 is held in the selection status. In this case, the voltage level $V_w$ of the word line 13-1 is "H" (high) as can be understood from Figure 3A. In Figure 3A, curves indicated by dotted lines, $30_{SN}$ and $30_{NS}$ are obtained, when the circuit 210 is not employed, and curves indicated by solid lines $31_{SN}$ and $31_{NS}$ are obtained, when the circuit 210 is employed. The curves $30_{SN}$ and $31_{SN}$ are obtained when a word line is changed from a selection status to a non-selection status. The curves $30_{NS}$ and $31_{NS}$ are obtained when another word line is changed from a non-selection status (N) to a selection status (S). Taking as an example the above mentioned case, the word lined 13-1 is changed from selection status to the non-selection status (corresponding to the curve $30_{SN}$ or $31_{SN}$ of Figure 3A). In this case, for example a word line 13-n (Figure 2A) is changed from a non-selection status to a selection status (corresponding to the curve $30_{NS}$ or $31_{NS}$ of Figure 3A). When the circuit 210 of Figure 2A is not employed, a cross point between the curves $30_{SN}$ and $30_{NS}$ occurs at a time t0, as illustrated in Figure 3A. It should be noted that data switching, from one of the memory cells of the word line 13-1 to one of the memory cells of the word line 13-n, occurs after the time t0. Accordingly, the time should be moved to the left in Figure 3A so as to achieve a high speed accessing of the desired memory cell. The hold-current controlling circuit 210 is useful for shifting the time t0 to a time t1. The reason for this is as follows. When the word line 13-1, is in selection status, the voltage level of the word line 13-1 is "H" (high). Accordingly, the voltage level of the hold line 15-1 is also "H". In this case, electric charges are held in the stray capacitor distributed along the word line 13-1 and also in the parasitic capacitors formed in the memory cells 21-11 through 21-1m. After this, when the word line 13-1 is changed from a selection status to a non-selection status, the electric charges held in the above mentioned capacitors, must be discharged very quickly, via the hold line 15-1. If there is no circuit 210, the discharge current is absorbed only by the source 23-1. However, if the circuit 210 is employed, only the diode 211-1 becomes conductive, and the discharge current can be absorbed not only by the source 23-1, but also by the source 212 of the circuit 210. Thus, the sharp slope of the curve $31_{SN}$ of Figure 3A can be obtained.

However, the circuit 210 has the following disadvantage. The disadvantage may be clarified with reference to Figure 3A. That is, although it would be preferable for the slope of the curve $31_{NS}$ to be sharp the corresponding portion of the curve $31_{NS}$ becomes a gradual curve, due to the presence of the circuit 210. This is because, when the word line 15-n is changed from a non-selection status to a selection status, the charging current for charging the above mentioned capacitors, is further absorbed by the constant-current source 212, via the diode 211-n which is now conductive. See the current $\Delta$Ih in Figure 3A.

It should be noted that in order to shift the time (t0) as far as possible to the left (in Figure 3A), the slope of the curve $30_{SN}$ must be very sharp and, at the same time, the slope of the curve $30_{NS}$ must also be very sharp.

Figure 2B illustrates a circuit diagram of a part of a semiconductor memory circuit including a second type of a prior art hold-current controlling circuit 220. A memory circuit that utilizes this hold-current controlling circuit 220 can improve the memory accessing characteristic, compared to that of a memory circuit utilizing the aforesaid circuit 210 of Figure 2A. This improvement will be clarified with reference to Figure 3B. In Figure 3B, a cross point between curves $32_{SN}$ and $32_{NS}$ occurs at a time t2 which is faster than the time t1 of Figure 3A, due to the presence of the circuit 220. This is because the current (Ih+$\Delta$Ih), which is absorbed by the constant-current source 23-1 and a current source 221-1, flows till the time t2' which follows after the time t2. Since the current (Ih+$\Delta$Ih) continues flowing after the time t2, slope of the curve $32_{SN}$ becomes sharper than that of the curve $31_{SN}$ of Figure 3A. However, the curve $32_{NS}$ is not improved, compared to the curve $31_{NS}$ of Figure 3A.

The hold-current controlling circuit 220, especially one of the current sources 221-1 through 221-n, has already been disclosed in the publication of "1979 IEEE International Solid-State Circuits Conference (ISSCC)/ Thursday, February 15, 1979/Grand Ballroom/11:45 A.M. (page 108)".

The operation of the current sources 221-1 through 221-n will now be described with reference to Figure 2B. When the voltage level of the word line 13-1 is "H", the voltage levels at points A and B are also "H". After this, when the word line 13-1 is changed from a selection status to a non-selection status, the voltage level at the point A decreases to "L" (low). However, the voltage level at the point B still maintains the voltage level "H", because of the electric charges held at a capacitor $C_2$. Then the electric charges of the capacitor $C_2$ discharge through a resistor $R_2$ with a time constant c2×r2, where the symbols c2 and r2 represent the capacitance value of the capacitor $C_2$ and the resistance value of the resistor $R_2$, respectively. During the time the voltage level at the point B decreases towards "L", a transistor $T_3$ is conductive. Therefore, a current $\Delta$Ih continues flowing after the time t2 of Figure 3b.

At the same time, the word line 13-n changes from a non-selection status to a selection status. In this case, the current source 221-n operates as follows. Since the circuit arrangement of the circuit 221-n is the same as the circuit arrangement of the circuit 221-1, the following explanation will be made with reference to the circuit elements of the circuit 221-1, as illustrated in Figure 2B. When the word line 13-n is in a non-selection status, the voltage levels of the points A and B are "L". After this, when the line 13-n changes from a non-selection status to a selection status, the voltage level at the point A increases to "H". Accordingly, a transistor $T_2$ becomes conductive. Then the capacitor $C_2$ is charged, and the voltage level at the point B increases toward "H". Accordingly, a transistor $T_3$ becomes conductive soon after the transistor $T_2$ becomes conductive. Therefore, a current $\Delta$Ih starts to flow, via the transistor $T_3$, after the time t2. See the current $\Delta$Ih of Figure 3B. Consequently, slope of the curve $32_{NS}$ (Figure 3B) is gradual, compared to that of the curve $30_{NS}$. A transistor $T_1$ receives, at its base, a reference voltage $V_{ref}$, so as to supply a predetermined level of the voltage to the point A.

Figure 2C depicts a circuit diagram of a part of a semiconductor memory circuit including a hold-current controlling circuit 230 of the invention of the present application. A memory circuit, that utilizes the hold-current controlling circuit 230 can improve the memory accessing characteristic, compared to that of a memory circuit utilizing the aforesaid circuit 220 of Figure 2B and circuit 210 of Figure 2A. This improvement will be clarified with reference to Figure 3C. In Figure 3C, a cross point between curves $33_{SN}$ and $33_{NS}$ occurs at a time t3 which is faster that the time t2 of Figure 3B, due to the presence of the circuit 230. This is because, a current (Ih+$\Delta$Ih), which is absorbed by the constant-current source 23-1 and the circuit 230, flows till the time t3' which follows after the time t3. Since the current (Ih+$\Delta$Ih) continues flowing after the time t3, the slope of the curve

$33_{SN}$ becomes sharper than that of the curve $31_{SN}$ of Figure 3A. Further, the slope of the curve $33_{NS}$ becomes sharper than that of the curve $31_{NS}$ of Figure 3A and the curve $32_{NS}$ of Figure 3B. That is, the slope of the curve $33_{NS}$ is substantially the same as that of the desired curve $30_{NS}$. A somewhat similar effect is obtained in the hold current controlling circuit shown in US—A—4 156 941 but this involves a complicated circuit connected to the word lines. The reason for this improvement is because the current $\Delta Ih$ does not start flowing from a time t3, but from a time t3″. Since the current $\Delta Ih$ is not absorbed from the hold line 15-n, when the corresponding line 13-n changes from a non-selection status to a selection status, the above mentioned parasitic capacitors and the stray capacitor, which both exist in the region including the word line 13-n and the memory cells of this line 13-n, can be charged very quickly by a current supplied from a word driver transistor 22-n, as illustrated in Figure 2C.

The time t3″ can be freely preset by suitably selecting the capacitance values of capacitors $C_{11}$ to $C_{n1}$ of Figure 2C and the resistance values of resistors $R_{11}$ through $R_{n1}$ of Figure 2C. In Figure 2C, each of the parallel circuits of the capacitors $C_{11}$ to $C_{n1}$ and the resistors $R_{11}$ to $R_{n1}$, is connected to Schottky transistors $ST_{11}$ to $ST_{n1}$, respectively. The emitters of the transistors $ST_{11}$ through $ST_{n1}$ are commonly connected to the constant-current source 212 (refer to Figure 2A).

As can be understood from Figure 2C, the circuit 230 of the present invention is very simple in construction, compared to that of the circuit 220 of Figure 2B, and to US—A—4 156 941. In particular, the number of capacitors and transistors are one-half the number used in the circuit 220.

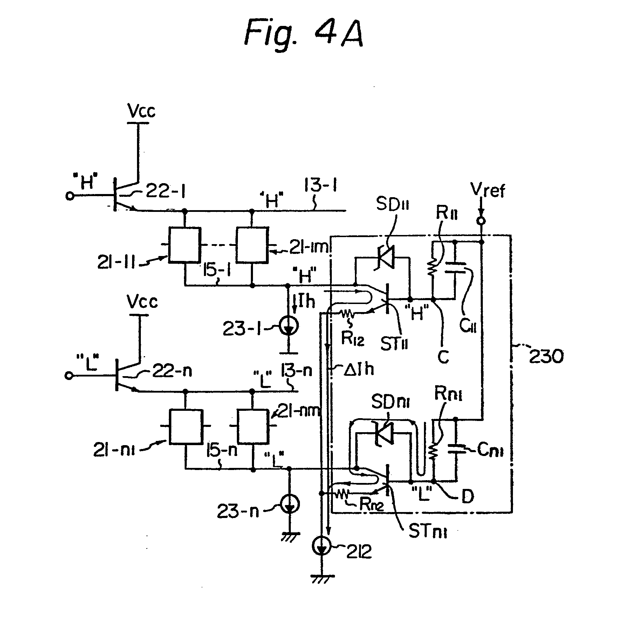

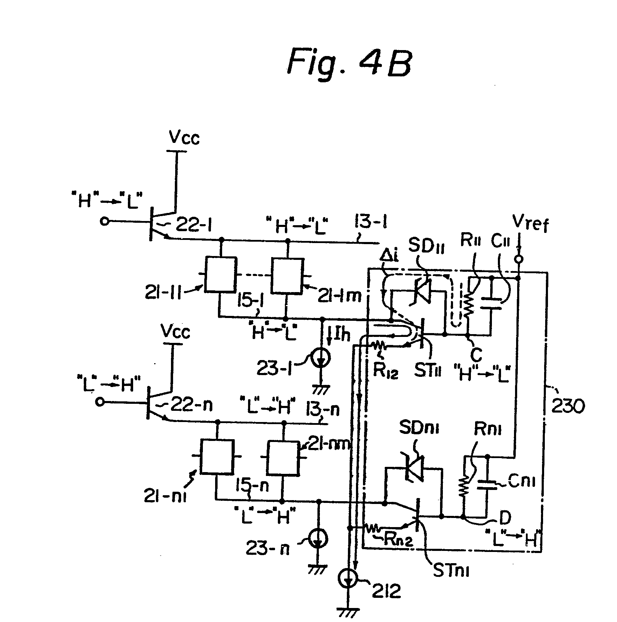

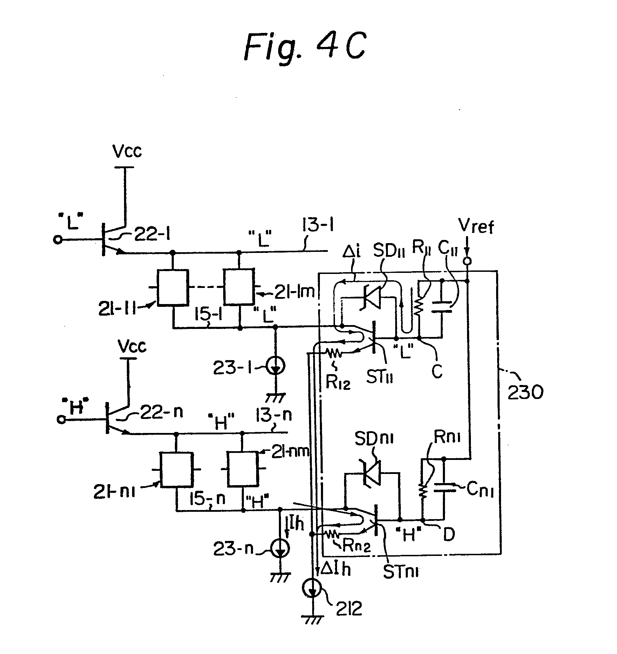

The operation of the hold-current controlling circuit 230 will be explained with reference to Figures 4A, 4B and 4C. First, referring to Figure 4A, when the word line 13-1 is in a selection status, the voltage level at the base of a transistor 22-1 is "H", and the voltage levels of the line 13-1 and the line 15-1 are also "H". Therefore, Schottky diode $SD_{11}$ is inversely biased. Since the Schottky diode is contained in the Schottky transistor, the Schottky diode $SD_{11}$ is not illustrated in Figure 2C, and further, it should be understood that if the transistor of the circuit 230 is made of a conventional transistor, a conventional diode must be inserted between the base and the collector of such usual transistor. In this case, the Schottky diode $SD_{11}$ is non-conductive, and the voltage level at a point C is "H". The level "H" is defined by the reference voltage $V_{ref}$. Since the voltage level at the point C is "H", the Schottky transistor $ST_{11}$ is conductive. Therefore, a current of full $\Delta Ih$ is absorbed by the constant-current source 212.

At the same time, the voltage level at the base of the transistor 22-n is "L", and the voltage levels of the line 13-n and the line 15-n are also "L". In this case, a Schottky diode $SD_{n1}$ is forwardly biased and a current $\Delta i$ flows from the voltage source $V_{ref}$ through the resistor $R_{n1}$ and the diode $SD_{n1}$. Accordingly, the voltage level at a point D is "L", and therefore the Schottky transistor $ST_{n1}$ is non-conductive. Since the current $\Delta i$ flows through the resistor $R_{n1}$, the magnitude of the current $\Delta i$ is far lower than that of the current $\Delta Ih$.

Next, referring to Figure 4B, when the word line 13-1 is changed from the selection status to the non-selection status, the word line 13-n is simultaneously changed from the non-selection status to the selection status. In this case, the voltage level at the base of the transistor 22-1 is changed from "H" to "L" and, accordingly, the voltage levels of the line 13-1 and the line 15-1 are changed from "H" to "L". Contrary to the above, the voltage level at the base of the transistor 22-n is changed from "L" to "H" and, accordingly, the voltage level of the line 13-n and the line 15-n are changed from "L" to "H". In this case, the diode $SD_{11}$ is changed from an inversely biassing mode to a forwardly biassing mode, while, the diode $SD_{n1}$ is changed from the forwardly biassing mode to the inversely biassing mode. It is very important to take note of the following facts. During the time when the voltage level of the line 15-1 changes from "H" to "L", the diode $SD_{11}$ is non-conductive. In other words, the diode $SD_{11}$ becomes conductive for the first time after the voltage level of the line 15-1 decreases to a full "L" level. This is because, the level of the reference voltage $V_{ref}$ is selected to be the value which is slightly above the level of full "L" plus the forward voltage of the diode. For example, if the full "L" is −1.6 V and the forward voltage is 0.4 V, the reference voltage $V_{ref}$ may be, for example −1.1 V. Consequently, in Figure 3C, the current ($Ih+\Delta Ih$) flows till the time t3′, which causes the curve $33_{SN}$ to have a sharp slope.

On the other hand, when the voltage level on the line 15-n changes from "L" to "H", the diode $SD_{n1}$ changes from a conductive condition to a non-conductive condition, almost instantly. However, the transistor cannot conduct significantly until the time constant of the parallel capacitor/resistor arrangement Cn1, Rn1 allows point D to rise somewhat above the L value.

Therefore, in Figure 3C, the current $\Delta Ih$ is not absorbed from the line 15-n (Figure 2C) during the interval from the time t3 to the time t3″, which causes creation of the curve $33_{NS}$, with substantially the same slope as the desired curve $30_{NS}$. The length of said interval (t3—t3″) can freely be determined by suitably selecting a time constant defined by both capacitors ($C_{11}$ to $C_{n1}$) and resistors ($R_{11}$ to $R_{n1}$).

Finally Figure 4C illustrates the completion of the data switching from a memory cell of the line 13-1 to a memory cell of the line 13-n. The word line 13-n is now in a selection status, the voltage level at the base of the transistor 22-n is "H" and the voltage levels of the line 13-n and the line 15-n are also "H". Therefore, the Schottky diode $SD_{n1}$ is inversely biased. In this case the Schottky diode $SD_{n1}$ is non-conductive, and the voltage level at the point D is "H". The level "H" is defined by the reference voltage $V_{ref}$. Since the voltage level of the point D is "H", the Schottky transistor $ST_{n1}$ is conductive. Therefore, a current of full $\Delta Ih$ is absorbed by the constant-current source 212.

At the same time, the voltage level at the base of the transistor 22-1 is "L" and the voltage levels of the line 13-1 and the line 15-1 are also "L". In this case, the Schottky diode $SD_{11}$ is forwardly biased and a current $\Delta i$ flows from the voltage source $V_{ref}$ through the resistor $R_{11}$ and the diode $SD_{11}$. Accordingly, the voltage level at the point C is "L", and therefore the Schottky transistor $ST_{11}$ is non-conductive. Since the current $\Delta i$ flows through the resistor $R_{11}$, the magnitude of current $\Delta i$ is far lower than current $\Delta Ih$.

As mentioned above, a high speed memory accessing operation is achieved for all switching states.

## Claims

1. A semiconductor memory circuit comprising memory cells (21-11, ... 21-nm), word lines (13-1, ... 13-n), hold lines (15-1, ... 15-n) and bit lines connected to the memory cells, first constant-current sources connected to the hold lines (23-1, ... 23-n) and a hold-current controlling circuit (230) co-operating with the first constant-current sources (23-1, ... 23-n), the hold-current controlling circuit (230) comprising identical controlling circuit elements connected to each of the hold lines (25-1, ... 25-n), and a second constant-current source (212) commonly connected to the controlling circuit elements, each of the controlling circuit elements including means for absorbing electric charges from its associated hold line (15-1, ... 15-n) when a corresponding word line (13-1, ... 13-n) changes from a selection status to a non-selection status, until the voltage level of the hold line reaches a full low level (L) and means for blocking a flow of electric charge from its associated hold line (15-1, ... 15-n) to the second constant current source (212) for a predetermined time interval after the corresponding word line changes from the non-selection status to the selection status when data switching from one of the memory cells to another memory cell occurs, characterised in that the controlling circuit elements are formed by a transistor (ST11), a diode (SD11), and a resistor (R11) and a capacitor (C11) connected in parallel, the base of the transistor (ST11) being connected to one end (C) of the parallel circuit, a first output terminal of the transistor being connected to its associated hold line (15-1) and a second output terminal of the transistor being connected to the second constant-current source (212), the diode (SD11) being connected between the first output terminal and the base of the transistor, and the other end of the parallel circuit being connected to a reference voltage (Vref), the reference voltage having a value such that the diode is forward biased when its associated hold line has a full low level and is reverse biased when the associated hold line has a full high level corresponding to a selection status.

2. A circuit according to claim 1, further characterised in that the transistor (ST11) and the diode (SD11) are formed in one element as a Schottky transistor.

3. A circuit according to claim 1 or claim 2, further characterised in that the level of the reference voltage (Vref) is selected to be a value which is slightly higher than the level of the full low level plus the forward voltage of the diode (SD11).

4. A circuit according to any of the preceding claims, further characterised in that the length of the predetermined interval is determined by the time constant of the capacitor (C11) and resistor (R11) in the parallel circuit.

## Patentansprüche

1. Halbleiterspeicherschaltung mit Speicherzellen (21-11, ... 21-nm), Wortleitungen (13-1, ... 13-n), Halteleitungen (15-1, ... 15-n) und Bitleitungen, welche mit den Speicherzellen verbunden sind, ersten Konstantstromquellen, welche mit den Halteleitungen (23-1, ... 23-n) verbunden sind und einer Haltestrom-Steuerschaltung (230), welche mit den ersten Konstantstromquellen (23-1, ... 23-n) kooperieren, bei welcher die Haltestromsteuerschaltung (230) identische Steuerschaltungselemente umfaßt, welche mit jeder der Halteleitungen (25-1, ... 25-n) verbunden sind, und eine zweite Konstantstromquelle (212), welche gemeinsam mit den Steuerschaltungselementen verbunden sind, die jeweils Einrichtungen zum Absorbieren elektrischer Ladungen von ihrer zugeordneten Halteleitung (15-1, ... 15-n) umfassen, wenn eine entsprechende Wortleitung (13-1, ... 13-n) von einem Selektionsstatus zu einem Nicht-Selektionsstatus übergeht, bis der Spannungspegel der Halteleitungen einen vollständig niedrigen Pegel (L) erreicht, und eine Einrichtung zum Blockieren des Flusses der elektrischen Ladung von ihrer zugeordneten Halteleitung (15-1, ... 15-n) zu der zweiten Konstantstromquelle (212) während eines vorbestimmten Zeitintervalls, nachdem die entsprechende Wortleitung von dem Nicht-Selektionsstatus in den Selektionsstatus übergegangen ist, wenn Datenumschaltung von einer der Speicherzellen zu einer anderen Speicherzelle auftritt dadurch gekennzeichnet, daß die Steuerschaltungselemente von einem Transistor (ST11), einer Diode (SD11) und

einem parallel mit einem Kondensator (C11) geschalteten Widerstand (R11) gebildet werden, die Basis des Transistors (ST11) mit einem Ende (C) der Parallelschaltung verbunden ist, ein erster Ausgangsanschluß des Transistors mit seiner zugeordneten Halteleitung (15-1) verbunden ist und ein zweiter Ausgangsanschluß des Transistors mit der zweiten Konstantstromquelle (212) verbunden ist, die Diode (SD11) zwischen den ersten Ausgangsanschluß und die Basis der Transistors geschaltet ist, und das andere Ende der Parallelschaltung mit einer Referenzspannung (Vref) verbunden ist, welche einen solchen Wert hat, daß die Diode in Vorwärtsrichtung vorgespannt ist, wenn ihre zugeordnete Halteleitung einen vollständigen niedrigen Pegel aufweist, und in Sperrichtung vorgespannt ist, wenn die zugeordnete Halteleitung einen vollständigen hohen Pegel hat, der einem Selektionsstatus entspricht.

2. Schaltung nach Anspruch 1, ferner dadurch gekennzeichnet, daß der Transistor (ST11) und die Diode (SD11) in einem Element als ein Schottky-Transistor ausgebildet sind.

3. Schaltung nach Anspruch 1 oder Anspruch 2, ferner dadurch gekennzeichnet, daß der Pegel der Referenzspannung (Vref) so ausgewählt ist, daß er einen Wert hat, der etwas höher als der Pegel des vollständigen niedrigen Pegels plus der Vorwärts-Spannung der Diode (SD11) ist.

4. Schaltung nach einem der vorhergehenden Ansprüche, ferner dadurch gekennzeichnet, daß die Länge des vorbestimmten Intervalls durch die Zeitkonstante des Kondensators (C11) und des Widerstands (R11) in der Parallelschaltung bestimmt ist.

**Revendications**

1. Circuit de mémoire à semi-conducteurs, comprenant des cellules de mémoire (21-11 ... 21-nm), des lignes demots (13-1 ... 13-n), des lignes de maintien (15-1 ... 15-n) et des lignes de bits connectées aux cellules de mémoire, des premières sources de courant constants connectées aux lignes de maintien (23-1 ... 23-n) et un circuit de contrôle de courant de maintien (230) coopérant avec les premières sources de courant constant (23-1 ... 23-n), le circuit de contrôle de courant constant (230) comprenant des éléments identiques de circuit de contrôle connectés à chacune des lignes de maintien (25-1 ... 25-n) et une seconde source de courant constant (212) connectée en commun aux éléments du circuit de contrôle, chacun des éléments de circuit de contrôle comprenant un dispositif pour absorber les charges électriques provenant de la ligne de maintien associée (15-1 ... 15-n) lorsqu'une ligne de mots correspondante (13-1 ... 13-n) passe d'un état de sélection à un état de non-sélection, jusqu'à ce que le niveau de tension de la ligne de maintien atteigne un niveau bas complet (L) et un dispositif pour bloquer la circulation d'une charge électrique depuis sa ligne de maintien associée (15-1 ... 15-n) vers la seconde source de courant constant (212) pendant un intervalle de temps prédéterminé après que la ligne de mots correspondante soit passée de l'état de non-sélection à l'état de sélection quand une commutation de données de l'une des cellules de mémoire vers une autre cellule de mémoire se produit, caractérisé en ce que les éléments de circuit de contrôle sont constitués par un transistor (ST11), une diode (SD11) et une résistance (R11) et un condensateur (C11) connectés en parallèle, la base du transistor (ST11) étant connectée à une extrémité (C) du circuit parallèle, une première bande de sortie du transistor étant connectée à sa ligne de maintien associée (15-1) et une seconde borne de sortie du transistor étant connectée à la seconde source de courant constant (212), la diode (SD11) étant connectée entre la première borne de sortie et la base du transistor et l'autre extrémité du circuit parallèle étant connectée à une tension de référence (Vref), la tension de référence ayant une valeur telle que la diode soit polarisée dans le sens direct lorsque sa ligne de maintien associée est complètement au niveau bas et soit polarisée dans le sens inverse quand la ligne de maintien associée se trouve complètement au niveau haut correspondant à un état de sélection.

2. Circuit selon la revendication 1, caractérisé en ce que, le transistor (ST11) et la diode (SD11) sont formés en une élément comme un transistor Schottky.

3. Circuit selon la revendication 1 ou la revendication 2, caractérisé en ce que le niveau de la tension de référence (Vref) est choisi de manière que sa valeur soit légèrement supérieure ou niveau du niveau bas complet, augmenté de la tension directe de la diode (SD11).

4. Circuit selon l'une quelconque des revendications précédentes, caractérisé en ce que la durée de l'intervalle prédéterminé est déterminée par la constante de temps du condensateur (C11) et de la résistance (R11) du circuit parallèle.

**0 024 853**

# Fig. 1

PRE-SENSE AMP *18*

SENSE AMP *19* → D out

*13*
*14*

WORD DECODER

A_0

A_{n-1}

MEMORY CELL ARRAY

*11* *15* *16* *17*

*12W*

BIT DECODER
*12B*

*14*

A_n

A_{n+m-1}

1

# Fig. 2A

# Fig. 2B

0 024 853

Fig. 2C

4

O 024 853

Fig. 3A

Fig. 3B

Fig. 3C

5

# Fig. 4A

**0 024 853**

*Fig. 4B*

7

Fig. 4C